# EUROPÄISCHE PATENTANMELDUNG

(11) **EP 1 814 231 A1**
(43) Veröffentlichungstag der Anmeldung: **01.08.2007**
(21) Anmeldenummer: 07001471.7
(22) Anmeldetag: 23.01.2007
(51) Int. Cl.: H03M 1/10

(54) **Verfahren zum Bestimmen und Verfahren zum Kompensieren einer Kennlinie eines A/D-Wandlers, Schaltungsanordnung zum Bestimmen einer solchen Kennlinie bzw. A/D-Wandler-Schaltungsanordnung**

(30) Priorität: 23.01.2006 DE 102006003282
(71) Anmelder: Micronas GmbH, 79108 Freiburg (DE)
(72) Erfinder: Bock, Christian, 79108 Freiburg (DE); Tereminac, Miodrag, 79194 Gundelfingen (DE)
(74) Vertreter: Patentanwälte Westphal, Mussgnug & Partner

(57) **Zusammenfassung**

Die Erfindung bezieht sich auf ein Verfahren zum Bestimmen einer Kennlinie eines A/D-Wandlers (AD), bei dem ein Testsignal an dem A/D-Wandler angelegt wird, digitale Werte (d) eines Ausgangssignals des A/D-wandlers mit einem Sollzustand des Ausgangssignals verglichen werden und abhängig vom Vergleichsergebnis zumindest ein Koeffizient zur späteren Korrektur von analog zu digitial umgesetzten Signalen bestimmt wird, wobei als der zumindest eine Koeffizient ein mehrdimensionaler Koeffizient mit zumindest zwei Dimensionen bestimmt wird. Die Erfindung bezieht sich außerdem auf ein Verfahren zum Kompensieren einer Kennlinie eines A/D-Wandlers (AD), bei dem mittels des A/D-Wandlers aus einem analogen Eingangssignal (a) ein Ausgangssignal aus digitalen Werten (d) erzeugt wird und die digitalen Werte mittels zumindest eines für diesen A/D-Wandler bereitgestellten Koeffizientens korrigiert werden, wobei zur Korrektur als der zumindest eine Koeffizient ein mehrdimensionaler Koeffizient (c; sc, dc) mit zumindest zwei Dimensionen verwendet wird. Gegenstand der Erfindung sind außerdem entsprechende Schaltungen zum Durchführen solcher Verfahren.

## Beschreibung

Die Erfindung bezieht sich auf ein Verfahren zum Bestimmen einer Kennlinie eines A/D-Wandlers (A/D: Analog/Digital) mit den oberbegrifflichen Merkmalen des Patentanspruchs 1, auf ein Verfahren zum Kompensieren einer Kennlinie eines A/D-Wandlers mit den oberbegrifflichen Merkmalen des Patentanspruchs 2, auf eine Schaltungsanordnung zum Bestimmen einer Kennlinie eines A/D-Wandlers mit den oberbegrifflichen Merkmalen des Patentanspruchs 12 bzw. auf eine A/D-Wandler-Schaltungsanordnung mit den oberbegrifflichen Merkmalen des Patentanspruchs 13.

A/D-Wandler wandeln eine analoge Eingangsspannung mit einer im Allgemeinen konstanten Abtastfrequenz als Ausgangssignal in einen digitalen Datenstrom aus digitalen Daten. Realisierbare A/D-Wandler haben nachteilhafter Weise keine ideale Kennlinie. Abweichungen von einer solchen idealen Kennlinie werden als DNL (Differendial Non-Linearity/Differenzielle NichtLinearität) bzw. INL (Integral Non-Linearity/Integrale NichtLinearität) bezeichnet, wobei die DNL einen maximalen Stufenbreitenfehler und die INL einen Fehler zwischen einem quantisierten Wert und einem idealen kontinuierlichen Wert bezeichnet.

Um diese Fehler zu verringern, kann bei bekannter Kennlinie des A/D-Wandlers ein spannungsabhängiger Korrekturwert zu dem digitalen Datenwort, welches eine Folge digitaler Daten bildet, addiert werden. Der Korrekturwert stammt beispielsweise aus einer Tabelle, in welcher alle spannungsabhängigen Korrekturwerte vorgehalten werden.

Die Kennlinie kann durch das Anlegen eines definierten und bekannten Signals ausgemessen werden. Üblich sind als ein solches Testsignal Spannungsrampen, Dreieck- oder Sinussignale. Eine von Temerinac et. al. konstruierte Kompensationsschaltung misst einen A/D-Wandler durch ein Sinussignal aus, welches auf der digitalen Seite mit einem rekonstruierten idealen Sinus verglichen wird. Parameter für Amplitude, Phase und Gleichspannungs-Offset dieses rekonstruierten Sinus werden aus dem gewandelten Signal mit Hilfe einer PLL (Phase Locked Loop/Phasengekoppelte Schleife) gewonnen. Aus den spannungsabhängigen Abweichungen zwischen den gewandelten und dem rekonstruierten Signal werden die Werte als Koeffizienten für die Korrekturtabelle gebildet. Beim Betrieb des A/D-Wandlers werden diese Koeffizienten vom Eingangssignal des A/D-Wandlers subtrahiert.

Ein solches Verfahren geht von einer statischen Kennlinie ohne Gedächtnis (memoryless) aus. Hat der A/D-Wandler jedoch in Abhängigkeit von der Vergangenheit des Signals verschiedene Zustände, so ist eine statische Kompensation der Kennlinie nicht ausreichend oder sogar unmöglich. Vielmehr ist für den Signalverlauf, das heißt jede Signalvergangenheit, ein anderer Satz von Korrektur-Koeffizienten zu erstellen und entsprechend ausgewählt anzuwenden. Dies führt jedoch zu einer Anzahl von (n+1)-dimensionalen Koeffizientenfeldern mit n als der Anzahl zu betrachtender vergangener Abtastwerte.

Es gibt Versuche, gedächtnisbehaftete A/D-Wandler durch Modelle (Volterra, Wiener) mathematisch zu beschreiben, beispielsweise in John Tsimbinos, Identification And Compensation of Non-Linear Distorsion, The Levels, Australien 1995, wobei solche Modelle jedoch zu aufwändigen Berechnungen führen.

Die Aufgabe der Erfindung besteht darin, eine möglichst einfache Fehlerkompensation für einen gedächtnisbehafteten A/D-Wandler zu entwickeln.

Diese Aufgabe wird gelöst durch ein Verfahren zum Bestimmen einer Kennlinie eines A/D-Wandlers gemäß den Merkmalen des Patentanspruchs 1, auf ein Verfahren zum Kompensieren einer Kennlinie eines A/D-Wandlers gemäß den Merkmalen des Patentanspruchs 2, auf eine Schaltungsanordnung zum Bestimmen einer Kennlinie eines A/D-Wandlers gemäß den Merkmalen des Patentanspruchs 12 bzw. auf eine A/D-Wandler-Schaltungsanordnung mit den Merkmalen des Patentanspruchs 13. Vorteilhafte Ausgestaltungen sind Gegenstand abhängiger Ansprüche.

Zum Bestimmen von Koeffizienten wird demgemäss bevorzugt ein Verfahren zum Bestimmen einer Kennlinie eines A/D-Wandlers, bei dem ein Testsignal an dem A/D-Wandler angelegt wird, digitale Werte eines Ausgangssignals des A/D-Wandlers mit einem Sollzustand des Ausgangssignals verglichen werden und abhängig vom Vergleichsergebnis zumindest ein Koeffizient zur späteren Korrektur von analog zu digitial umgesetzten Signalen bestimmt wird, wobei als der zumindest eine Koeffizient ein mehrdimensionaler Koeffizient mit zumindest zwei Dimensionen bestimmt wird.

Zum Kompensieren einer Kennlinie eines A/D-Wandlers wird demgemäss bevorzugt ein Verfahren, bei dem mittels des A/D-Wandlers aus einem analogen Eingangssignal ein Ausgangssignal aus digitalen Werten erzeugt wird und die digitalen Werte mittels zumindest eines für diesen A/D-Wandler bereitgestellten Koeffizientens korrigiert werden, wobei zur Korrektur als der zumindest eine Koeffizient ein mehrdimensionaler Koeffizient mit zumindest zwei Dimensionen verwendet wird.

Vorteilhaft ist ein Verfahren, bei dem je weiterer Dimension des zumindest einen mehrdimensionalen Koeffizienten ein zusätzlicher weiter zurückliegend vergangener Eingangswert berücksichtigt wird. Vorteilhaft ist ein Verfahren, bei dem durch die mehrdimensionale Verarbeitung sowohl ein statischer Koeffizient als auch zusätzlich zumindest ein dynamischer Koeffizient als der mehrdimensionale Koeffizient berücksichtigt wird.

Vorteilhaft ist ein Verfahren, bei dem eine Wiederholungsrate der dynamischen Koeffizienten berücksichtigt wird. Dabei ist vorteilhaft, wenn die Wiederholungsrate einer Faltungsstruktur des A/D-Wandlers entsprechend festgelegt wird und wenn die Wiederholungsrate einer Anzahl von Korrekturfeldern über eine Wandleraussteuerung des A/D-Wandlers entsprechend festgelegt wird.

Vorteilhaft ist ein Verfahren, bei dem zur Koeffizientenbestimmung eine Kerbfilterung verwendet wird, welche eine Anzahl von Filterfrequenzen entsprechend einer Anzahl von Testsignalfrequenzen verwendet, welche zur Bestimmung des zumindest einen mehrdimensionalen Koeffizienten verwendet wurden. Vorteilhaft ist insbesondere dabei, wenn eine Kerbfilterung verwendet wird, wobei Parameter derart eingestellt werden, dass möglichst wenig oder keine zurückgefaltete Oberwellen in Bereiche um Testsignalfrequenzen fallen, welche zur Bestimmung des zumindest einen mehrdimensionalen Koeffizienten verwendet wurden.

Vorteilhaft ist ein Verfahren, bei dem eine Kerbfilterung unter Berücksichtigung von mehreren Testsignalfrequenzen anstelle einer PLL (phasengekoppelte Schleife/Phase Locked Loop) verwendet wird.

Vorteilhaft ist ein Verfahren, bei dem das Testsignal zur Bestimmung des zumindest einen mehrdimensionalen Koeffizienten aus zumindest zwei überlagerten Eingangssignalen unterschiedlicher Testsignalfrequenz gebildet wird.

Vorrichtungsgemäß wird demgemäss bevorzugt eine Schaltungsanordnung zum Bestimmen einer Kennlinie eines A/D-Wandlers mit dem A/D-Wandler, einem Signaleingang zum Anlegen eines Testsignals an den A/D-Wandler, einer Koeffizienten-Bestimmungseinrichtung zum Bestimmen zumindest eines Koeffizienten durch Vergleichen digitaler Werte eines Ausgangssignals des A/D-Wandlers mit einem Sollzustand des Ausgangssignals und einer Speichereinrichtung zum Speichern des zumindest einen Koeffizientens für eine spätere Kennlinienkorrektur, wobei die Koeffizienten-Bestimmungseinrichtung ausgelegt ist, zumindest einen mehrdimensionalen Koeffizienten mit zumindest zwei Dimensionen als Basis für Korrekturwerte für den A/D-Wandler zu bestimmen.

Bevorzugt wird vor allem eine A/D-Wandler-Schaltungsanordnung mit einem A/D-Wandler, einem Signaleingang zum Anlegen eines analogen Eingangssignals an den A/D-Wandler, einem Signalausgang zum Ausgeben von digitalen Werten, welche durch den A/D-Wandler aus dem analogen Eingangssignal erzeugt wurden, und einer Korrektureinrichtung zum Korrigieren der vom A/D-Wandler ausgegebenen digitalen Werte mittels zumindest eines bereitgestellten Koeffizienten hinsichtlich einer Kennlinie des A/D-Wandlers, wobei die Korrektureinrichtung ausgelegt ist, die ausgegebenen digitalen Werte mittels des als mehrdimensional, zumindest zweidimensional bereitgestellten Koeffizientens zu korrigieren.

Vorteilhaft ist eine Schaltungsanordnung, bei der die Korrektureinrichtung ausgelegt ist, einen statischen Korrekturwert und einen dynamischen Korrekturwert zu erzeugen und diese von durch den A/D-Wandler ausgegebenen digitalen Werten zu subtrahieren.

Vorteilhaft ist eine Schaltungsanordnung, bei der die Korrektureinrichtung ausgelegt ist, einen statischen Koeffizienten zum Erzeugen eines statischen Korrekturwertes und zumindest einen dynamischen Koeffizienten zum Erzeugen eines dynamischen Korrekturwertes bereitzustellen und zu verwenden.

Vorteilhaft ist eine Schaltungsanordnung, bei der die Korrektureinrichtung ausgelegt ist, dynamische Koeffizienten mittels einer Modulo-Schaltung abhängig von einer Wiederholungsrate einer Wandlerstruktur des A/D-Wandlers zur Korrektur auszuwählen.

Vorteilhaft ist eine Schaltungsanordnung, bei der die vom A/D-Wandler ausgegebenen digitalen Werte einem Eingang eines Subtraktionsglieds und einem Eingang eines Verzögerungsglieds angelegt werden, wobei ein Ausgang des Verzögerungsglieds an einem weiteren Eingang des Subtraktionsglieds anliegt und ein Ausgang des Subtraktionsglieds an der Korrektureinrichtung zum Erzeugen von dynamischen Korrekturwerten unter Berücksichtigung der dynamischen Koeffizienten anliegt.

Vorteilhaft ist eine Schaltungsanordnung mit einem Kerbfilter zum Filtern der vom A/D-Wandler ausgegebenen digitalen Werte unter Berücksichtigung von Testsignalfrequenzen, welche zur Koeffizientenbestimmung verwendet wurden und/oder mit einem Kerbfilter zum Filtern der vom A/D-Wandler ausgegebenen digitalen Werte zum Bereitstellen von Aktualisierungswerten für die Koeffizienten.

Die Verfahren und Schaltungsanordnungen beruhen dabei auf Untersuchungen, welche gezeigt haben, dass für die Gedächtnislänge eines beispielhaften A/D-Wandlers oftmals eine Betrachtung der letzten zwei vergangenen Eingangswerte genügt. Damit wird anstelle einer eindimensionalen Korrekturtabelle mit einem eindimensionalen Koeffizienten eine Korrekturtabelle mit drei Dimensionen bzw. dreidimensionalen Koeffizienten erhalten. Bereits bei der Betrachtung nur des letzten Eingangswertes und der Erstellung einer nur zweidimensionalen Korrekturtabelle mit zumindest einem zweidimensionalen Koeffizienten ergibt sich eine starke Verbesserung gegenüber dem statischen Modell, so dass eine Verwendung zweidimensionaler Koeffizienten zwar in vielen Fällen noch nicht sehr gute jedoch ausreichende Ergebnisse erzielen lässt und entsprechend ebenfalls als vorteilhaft erkannt wird.

Unter einer mehrdimensionalen Fehlerkomponente bzw. mehrdimensionalen Koeffizienten wird auch eine Aufsplittung in statische und dynamische Anteile verstanden. Ein Großteil einer dynamischen Fehlerkomponente stammt von der Faltungsarchitektur des A/D-Wandlers, was für sich genommen bekannt ist aus z. B. Michael P. Flynn, CMOS Folding A/D Converters With Current-Mode Interpolation, IEEE Journal of Solid-State Circuits 31 No.9, September 1996, Seite 2348 ff. Der dyanmische Anteil wiederholt sich entsprechend der Faltungsstruktur im Falle eines Wortes aus digitalen Daten achtmal über die Aussteuerungsbreite des A/D-Wandlers. Eine Aufspaltung der Korrektur-Koeffizienten in einen statischen und in einen dynamischen Anteil führt zu einem vorteilhaften Speicherbedarf von k + k*k/8 im Gegensatz zu k² für eine volle Ausbildung des Koeffizientenfeldes mit k als Anzahl der Korrekturfelder über die Wandleraussteuerung.

Um eine genügende Abdeckung des zweidimensionalen Koeffizientenfeldes zu erzielen, besteht das Messsignal als ein Testsignal, welches zum Bestimmen der Koeffizienten an den A/D-Wandler angelegt wird, aus einer Summe von zwei Sinussignalen unterschiedlicher Frequenz. Um auf der Empfänger-(A/D)-Seite für die Fehlerbestimmung jeweils Amplitude, Frequenz und Phase der beiden Originalsignale abschätzen zu können, werden üblicherweise PLL-Schaltungen eingesetzt. Stattdessen wird jedoch vorzugsweise mit zwei Kerbfiltern gearbeitet, was den Aufwand für die Realisierung einer Schaltungsanordnung zum Bestimmen mehrdimensionaler Koeffizienten erheblich vermindert. Bei höherdimensionalen Koeffizientenfeldern zur Berücksichtigung weiter zurückliegender Signalvergangenheiten wird mit entsprechend mehr Kerbfiltern gearbeitet.

Ein Ausführungsbeispiel wird nachfolgend anhand der Zeichnung näher erläutert. Es zeigen:
- Fig. 1: eine Schaltungsanordnung zum Bestimmen einer Kennlinie eines A/D-Wandlers und zum Bestimmen von Korrektur-Koeffizienten,
- Fig. 2: eine A/D-Wandler-Schaltungsanordnung mit einer Kennlinien-Kompensation unter Verwendung mehrdimensionaler Koeffizienten,
- Fig. 3: einen Phasengang in Abtastzeit von verwendeten Kerbfiltern,
- Fig. 4: eine Modulo-8-Darstellung dynamischer Koeffizienten in der unteren Abbildung und statischer Koeffizienten in der oberen Abbildung,
- Fig. 5: eine Abweichung einer Wandler-Kennlinie von einer Original-Kennlinie bei einem Abtastwert Vergangenheit und Zweitonaussteuerung mit dunkel dargestellten negativen Abweichungen und mit hell dargestellten positiven Abweichungen und
- Fig. 6: ein 48 x 48 -Korrekturfeld mit einer Differenz zwischen letztem und aktuellem Abtastwert (y-Achse) dargestellt über dem aktuellen Abtastwert (x-Achse).

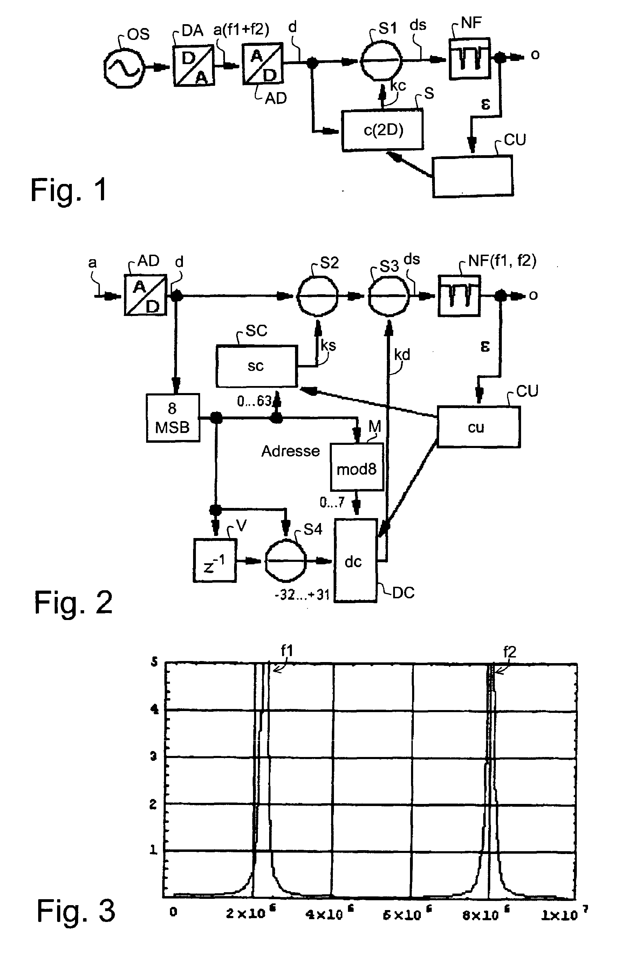

Wie dies aus Fig. 1 ersichtlich ist, besteht eine Schaltungsanordnung zum Bestimmen einer Kennlinie eines A/D-Wandlers AD aus einer Vielzahl von Komponenten, welche auch in einer A/D-Wandler-Schaltungsanordnung zum Umsetzen eines analogen Signals in ein Ausgangssignal aus digitalen Werten eingesetzt werden. Entsprechend zeigt Fig. 1 lediglich eine beispielhafte bevorzugte Anordnung eines Testgenerators.

Von einer Signalquelle OS in Form eines oder mehrerer Oszillatoren wird ein Signal bereitgestellt und einem D/A-Wandler (D/A: Digital/Analog) angelegt, um ein analoges Testsignal a(f1+f2) mit zwei Testsignalfrequenzen f1, f2 bereitzustellen. Dieses analoge Testsignal a(f1+f2) wird einem A/D-Wandler AD angelegt, dessen Kennlinie zu bestimmen ist, um abhängig von der Kennlinie entsprechende Koeffizienten c(2D) zur späteren Korrektur von regulär umgesetzten digitalen Daten durchzuführen. Der A/D-Wandler AD gibt entsprechend als Ausgangssignal digitale Werte d aus, welche einem Subtraktionsglied S1 angelegt werden. Dem Subtraktionsglied S1 werden an einem zweiten Eingang Korrekturwerte kc angelegt. Ein Ausgang des Subtraktionsglieds S1 stellt eine Abfolge korrigierter digitaler Daten ds bereit, welche einer Kerbfilterung in zwei Kerbfiltern NF zugeführt wird, wobei die Kerbfilterung die Korrektursignalfrequenzen f1, f2 berücksichtigt. Eine derart durch die Kerbfilterung gefilterte Folge von Werten wird als Ausgangssignal o bereitgestellt. Außerdem werden die durch die Kerbfilterung gefilterten Werte oder eine daraus abgeleitete Größe als ein Vergleichsergebnis einer Koeffizienten-Bestimmungseinrichtung CU zugeführt, welche entsprechende Koeffizienten bestimmt und/oder aktualisiert. Derart bereitgestellte Koeffizienten werden als die Koeffizienten c(2D) in einer Koeffizienten-Speichereinrichtung S bereitgestellt, wobei die Koeffizienten-Speichereinrichtung S bei der dargestellten Ausführungsform zugleich als eine Einrichtung zum Bereitstellen der Korrekturwerte kc dient. Dazu wird der Einrichtung zum Bereitstellen der Korrekturwerte kc zusätzlich die Folge der digitalen Werte d des A/D-Wandlers AD angelegt.

Zur Bestimmung eines Kennlinienfeldes bzw. zur Bestimmung mehrdimensionaler, im vorliegenden Beispiel zweidimensionaler Koeffizienten c(2D), wird der A/D-Wandler AD dieser Ausführungsform mit zwei Sinussignalen angesteuert, welche sich hinsichtlich deren Frequenzen in Form der beiden Testsignalfrequenzen f1, f2 unterscheiden. Eine Regelschleife setzt das Koeffizientenfeld auf die Abweichung zu idealen Sinussignalen.

Fig. 2 zeigt ein Blockschaltbild einer zweidimensionalen Kompensation mit statischem Anteil und einem sich achtfach wiederholenden dynamischen Anteil. Gegenüber der dargestellten Ausführungsform sind Abwandlungen umsetzbar, insbesondere im Fall einer unterschiedlichen Anzahl sich wiederholender dynamischer Anteile oder im Fall eines höherdimensionalen Koeffizientenfeldes, welches durch eine Erzeugung der Koeffizienten mittels einer höheren Anzahl von Testsignalfrequenzen erstellbar ist.

Ein in digitale Werte d umzusetzendes analoges Eingangssignal a wird einem A/D-Wandler AD angelegt, zu dem entsprechende Koeffizienten bekannt sind bzw. bestimmt wurden. Der A/D-Wandler AD gibt die digitalen Werte d aus, welche einem oder mehreren Subtraktionsgliedern S2, S3 angelegt werden, um Korrekturwerte ks, kd zu subtrahieren. Von der Folge der Subtraktionsglieder S2, S3 wird eine Abfolge entsprechend korrigierter digitaler Daten ds ausgegeben, welche einer Kerbfilterung in einer Abfolge aus Kerbfiltern NF angelegt wird. Die Kerbfilterung in den Kerbfiltern NF berücksichtigt wieder die Testsignalfrequenzen f1, f2, welche zur Erstellung der Koeffizienten verwendet wurden. Ausgegeben wird von den Kerbfiltern NF eine Folge digitaler Werte als eigentliches Ausgangssignal o. Außerdem wird die Folge digitaler Werte der Kerbfilter NF vorzugsweise als ein Vergleichsergebnis oder Wert ε einer Koeffizienten-Bestimmungseinrichtung CU angelegt, welche mehrdimensionale, vorliegend zweidimensionale Koeffizienten sc, dc bestimmt und in entsprechenden Speichereinrichtungen SC, DC bereitstellt.

Die Speichereinrichtungen SC, DC sind zugleich Bestandteil einer Korrektureinrichtung, welche mittels angelegter digitaler Daten d, welche gegebenenfalls vorverarbeitet sind, die beiden Korrekturwerte bzw. Abfolgen von Korrekturwerten ks, kd bereitstellen, welche den Subtraktionsgliedern S2 bzw. S3 angelegt werden zur Subtraktion von den momentan vom A/D-Wandler AD ausgegebenen digitalen Werten d. Die digitalen Werte d, welche vom A/D-Wandler AD ausgegeben werden, werden außerdem einer Einrichtung 8 MSB (Most Significant Bit) zur Bestimmung und/oder Auswahl von acht signifikantesten Bit angelegt, welche entsprechende Werte ausgibt und im dargestellten Beispiel in einer Folge von 0...63 an eine erste Komponente der Korrektureinrichtung anlegt. Diese Komponente umfasst zugleich die erste Speichereinrichtung SC, in welcher statische Koeffizienten sc als ein Teil der mehrdimensionalen Koeffizienten hinterlegt sind. Mittels der angelegten digitalen Werte d und der statischen Koeffizienten sc werden die ersten Korrekturwerte ks der Korrekturwerte erzeugt und dem ersten der Subtraktionsglieder S2 angelegt.

Außerdem werden die von der Einrichtung 8 MSB zur Bestimmung der acht signifikantesten Bit ausgegebenen Daten einer Modulo-Einrichtung M angelegt, welche eine Wiederholungsrate mod8 berücksichtigt, wobei die Wiederholungsrate mod8 einer Wandlerstruktur des A/D-Wandlers AD entspricht. Dabei wird vorliegend von 8-Bit-Worten ausgegangen, welche vom A/D-Wandler AD als digitale Daten d zur Verfügung gestellt werden. Die Modulo-Einrichtung M gibt entsprechend verzögert Daten, insbesondere die hier momentan anliegenden digitalen Daten d, an die zweite Komponente der Korrektureinrichtung, welche die zweite Speichereinrichtung DC umfasst. In der zweiten Speichereinrichtung DC sind entsprechend dynamische Koeffizienten dc als ein weiterer Bestandteil der mehrdimensionalen Koeffizienten bereitgestellt, wobei die Korrektureinrichtung mit den anliegenden Daten und dem dynamischen Koeffizienten dc die weiteren Korrekturdaten als dynamische Korrekturdaten kd erzeugt und dem zweiten Subtraktionsglied S3 anlegt.

Von der Einrichtung 8 MSB zur Bestimmung der acht höchstwertigsten Bit ausgegebene Werte werden außerdem einem Verzögerungsglied V und einem Eingang eines dritten Subtraktionsglieds S4 angelegt. Das Verzögerungsglied V nimmt eine Verzögerung um einen Wert bzw. einen Takt vor und legt einen entsprechend verzögerten Wert von seinem Ausgang an einen weiteren Eingang des dritten Subtraktionsglieds S4 an. Die Ausgangswerte des dritten Subtraktionsglieds S4 werden über dessen Ausgang an die zweite Komponente der Korrektureinrichtung, welche die dynamischen Koeffizienten hält, als weiteres Eingangssignal angelegt.

Mittels einer solchen beispielhaften Schaltung wird entsprechend eine Untergliederung der mehrdimensionalen Koeffizienten in einen statischen und einen dynamischen Anteil vorgenommen, um entsprechend statische Korrekturwerte ks bzw. dynamische Korrekturwerte kd zu bestimmen, welche dann von momentan ausgegebenen digitalen Werten d des A/D-Wandlers AD abgezogen werden. Vorzugsweise wird wieder eine Regelschleife über eine Kerbfilteranordnung vorgenommen, wobei die Kerbfilteranordnung die Testsignalfrequenzen f1, f2 berücksichtigt, welche zur Erstellung der mehrdimensionalen Koeffizienten sc, dc verwendet wurden, wie dies beispielhaft aus Fig. 3 ersichtlich ist.

Bei der Anwendung von Kerbfiltern anstelle von phasengekoppelten Schleifen (PLLs) ist vorzugsweise darauf zu achten, dass keine oder möglichst wenig von zurückgefalteten Oberwellen, die durch Wandler-Nicht-Linearitäten entstehen, in den Bereich um die Testsignalfrequenzen f1, f2 fallen, da die Kerbfilter dort einen Phasengang haben, welcher die Bestimmung gültiger Korrektur-Koeffizienten nachteilhaft beeinflusst oder gegebenenfalls sogar unmöglich macht. Die Messfrequenzen bzw. Testsignalfrequenzen f1, f2 können so gewählt werden, dass sie das spätere Nutzsignal annähern, also z. B. bei einem Fernsehsignal Frequenzen von Bild- und Tonträgern entsprechen. Umsetzbar ist das Konzept auf alle Arten von A/D-Wandlern, bei der Reduzierung des Koeffizientenfeldes, insbesondere im Fall von Faltungs-A/D-Wandlern, sofern derartige Wandler ein so genanntes Gedächtnis aufweisen.

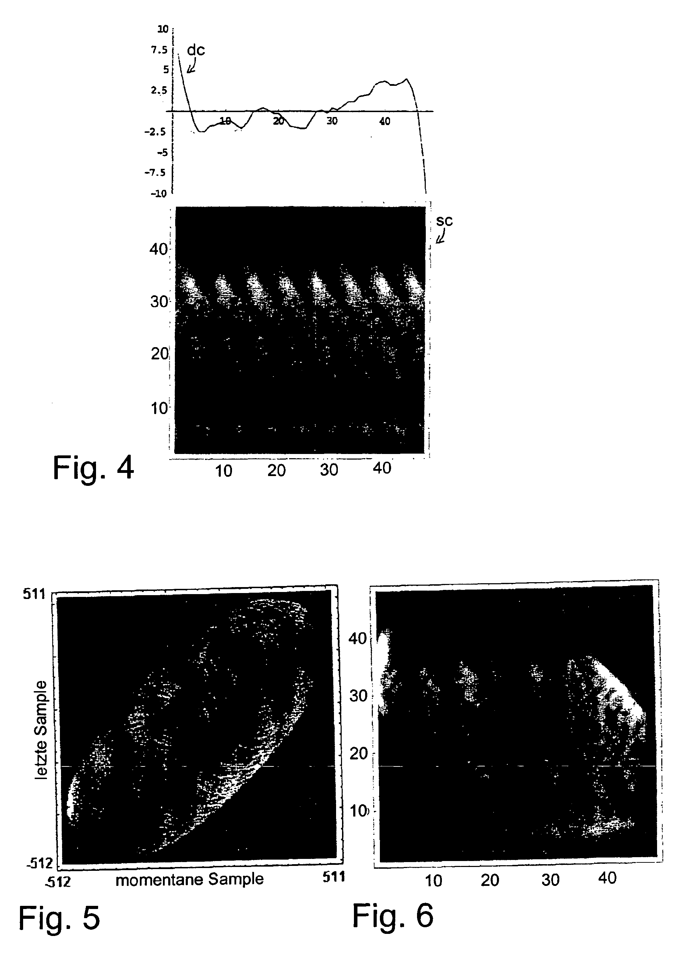

Fig. 4 zeigt beispielhaft für den Fall einer Wiederholungsrate mod8 eine Modulo-8-Darstellung der dynamischen Koeffizienten dc im unteren Bild und der statischen Koeffizienten sc im oberen Bild.

Fig. 5 zeigt eine Abweichung einer Wandler-Kennlinie von einer Original-Kennlinie bei einem Abtastwert Vergangenheit für den Fall einer Zweitonaussteuerung, wobei dunkel negative Abweichungen und hell positive Abweichungen skizziert sind. Die Achtfach-Struktur des Faltungswandlers ist dabei deutlich zu erkennen. Fig. 6 zeigt ein 48 x 48-Korrekturfeld mit einer Differenz zwischen letztem und aktuellem Abtastwert aufgetragen über einem aktuellen Abtastwert. Zu erkennen ist, dass die Achtfach-Struktur auf eine Höhe der y-Achse kommt, wenn statt des vergangenen Abtastwertes die Differenz von einem vergangenen zu einem aktuellen Abtastwert dargestellt wird, wie dies in Fig. 6 abgebildet ist. Erkennbar ist eine Aufspaltung in einen sich achtfach wiederholenden dynamischen und in einen statischen Anteil, was ausnutzbar ist in der Ausbildung der dynamischen Koeffizienten dc und der Bereitstellung der dynamischen Korrekturwerte kd unter Berücksichtigung der Wiederholungsrate mod8. Erzielbar ist dadurch insbesondere eine deutliche Verringerung des benötigten Gesamtspeicherplatzes durch einen geringeren Speicherbedarf in der zweiten Speichereinrichtung DC für die dynamischen Koeffizienten dc. Natürlich kann anstelle zweier getrennter Speichereinrichtungen SC, DC auch eine gemeinsame Speichereinrichtung eingesetzt werden.

Auch die Untergliederung der Korrektureinrichtung in zwei Korrektureinrichtungen ist nicht zwingend in der dargestellten Form erforderlich.

## Patentansprüche

1. Verfahren zum Bestimmen einer Kennlinie eines A/D-Wandlers (AD), bei dem
- ein Testsignal (a(f1+f2)) an dem A/D-Wandler (AD) angelegt wird,
- digitale Werte (d) eines Ausgangssignals des A/D-Wandlers (AD) mit einem Sollzustand des Ausgangssignals verglichen werden und
- abhängig vom Vergleichsergebnis zumindest ein Koeffizient zur späteren Korrektur von analog zu digitial umgesetzten Signalen bestimmt wird,
**dadurch gekennzeichnet, dass**
- als der zumindest eine Koeffizient ein mehrdimensionaler Koeffizient (c; sc, dc) mit zumindest zwei Dimensionen bestimmt wird.

2. Verfahren zum Kompensieren einer Kennlinie eines A/D-Wandlers (AD), bei dem
- mittels des A/D-Wandlers (AD) aus einem analogen Eingangssignal (a) ein Ausgangssignal aus digitalen Werten (d) erzeugt wird und
- die digitalen Werte (d) mittels zumindest eines für diesen A/D-Wandler (AD) bereitgestellten Koeffizientens korrigiert werden,
**dadurch gekennzeichnet, dass**
zur Korrektur als der zumindest eine Koeffizient ein mehrdimensionaler Koeffizient (c; sc, dc) mit zumindest zwei Dimensionen verwendet wird.

3. Verfahren nach Anspruch 1 oder 2, bei dem je weiterer Dimension des zumindest einen mehrdimensionalen Koeffizienten (sc, dc) ein zusätzlicher weiter zurückliegend vergangener Eingangswert (z⁻¹) berücksichtigt wird.

4. Verfahren nach einem vorstehenden Anspruch, bei dem durch die mehrdimensionale Verarbeitung sowohl ein statischer Koeffizient (sc) als auch zusätzlich zumindest ein dynamischer Koeffizient (dc) als der mehrdimensionale Koeffizient berücksichtigt wird.

5. Verfahren nach Anspruch 4, bei dem eine Wiederholungsrate (mod8) der dynamischen Koeffizienten (dc) berücksichtigt wird.

6. Verfahren nach Anspruch 5, bei dem die Wiederholungsrate (mod8) einer Faltungsstruktur des A/D-Wandlers (AD) entsprechend festgelegt wird.

7. Verfahren nach Anspruch 5 oder 6, bei dem die Wiederholungsrate (mod8) einer Anzahl von Korrekturfeldern über eine Wandleraussteuerung des A/D-Wandlers (AD) entsprechend festgelegt wird.

8. Verfahren nach einem vorstehenden Anspruch, bei dem zur Koeffizientenbestimmung eine Kerbfilterung verwendet wird, welche eine Anzahl von Filterfrequenzen entsprechend einer Anzahl von Testsignalfrequenzen (f1, f2) verwendet, welche zur Bestimmung des zumindest einen mehrdimensionalen Koeffizienten (sc, dc) verwendet wurden.

9. Verfahren nach einem vorstehenden Anspruch, bei dem eine Kerbfilterung verwendet wird, wobei Parameter derart eingestellt werden, dass möglichst wenig oder keine zurückgefaltete Oberwellen in Bereiche um Testsignalfrequenzen (f1, f2) fallen, welche zur Bestimmung des zumindest einen mehrdimensionalen Koeffizienten (sc, dc) verwendet wurden.

10. Verfahren nach einem vorstehenden Anspruch, bei dem eine Kerbfilterung unter Berücksichtigung von mehreren Testsignalfrequenzen (f1, f2) anstelle einer PLL (phasengekoppelte Schleife/Phase Locked Loop) verwendet wird.

11. Verfahren nach Anspruch 1 oder einem der Ansprüche 8 bis 10, bei dem das Testsignal (a(f1+f2)) zur Bestimmung des zumindest einen mehrdimensionalen Koeffizienten (sc, dc) aus zumindest zwei überlagerten Eingangssignalen unterschiedlicher Testsignalfrequenz (f1, f2) gebildet wird.

12. Schaltungsanordnung zum Bestimmen einer Kennlinie eines A/D-Wandlers (AD) mit
- dem A/D-Wandler (AD),
- einem Signaleingang zum Anlegen eines Testsignals (a(f1+f2)) an den A/D-Wandler (AD),
- einer Koeffizienten-Bestimmungseinrichtung (CU) zum Bestimmen zumindest eines Koeffizienten durch Vergleichen digitaler Werte (d) eines Ausgangssignals des A/D-Wandlers mit einem Sollzustand des Ausgangssignals und
- einer Speichereinrichtung (S) zum Speichern des zumindest einen Koeffizientens für eine spätere Kennlinienkorrektur,
**dadurch gekennzeichnet, dass**
- die Koeffizienten-Bestimmungseinrichtung (cu) ausgelegt ist, zumindest einen mehrdimensionalen Koeffizienten (sc, dc) mit zumindest zwei Dimensionen als Basis für Korrekturwerte für den A/D-Wandler (AD) zu bestimmen.

13. A/D-Wandler-Schaltungsanordnung mit
- einem A/D-Wandler (AD),
- einem Signaleingang zum Anlegen eines analogen Eingangssignals (a) an den A/D-wandler (AD),
- einem Signalausgang zum Ausgeben von digitalen Werten (d), welche durch den A/D-Wandler aus dem analogen Eingangssignal (a) erzeugt wurden, und
- einer Korrektureinrichtung zum Korrigieren der vom A/D-Wandler (AD) ausgegebenen digitalen Werte (d) mittels zumindest eines bereitgestellten Koeffizienten hinsichtlich einer Kennlinie des A/D-Wandlers (AD),
**dadurch gekennzeichnet, dass***
- die Korrektureinrichtung (CU, SC, DC) ausgelegt ist, die ausgegebenen digitalen Werte (d) mittels des als mehrdimensional, zumindest zweidimensional bereitgestellten Koeffizientens (sc, dc) zu korrigieren.

14. Schaltungsanordnung nach Anspruch 13, bei der die Korrektureinrichtung (CU, SC, DC) ausgelegt ist, einen statischen Korrekturwert (ks) und einen dynamischen Korrekturwert (kd) zu erzeugen und diese von durch den A/D-Wandler (AD) ausgegebenen digitalen Werten (d) zu subtrahieren.

15. Schaltungsanordnung nach Anspruch 14, bei der die Korrektureinrichtung (CU, SC, DC) ausgelegt ist, einen statischen Koeffizienten (sc) zum Erzeugen eines statischen Korrekturwertes (ks) und zumindest einen dynamischen Koeffizienten (dc) zum Erzeugen eines dynamischen Korrekturwertes (kd) bereitzustellen und zu verwenden.

16. Schaltungsanordnung nach Anspruch 14 oder 15, bei der die Korrektureinrichtung (CU, DC) ausgelegt ist, dynamische Koeffizienten (dc) mittels einer Modulo-Schaltung (M) abhängig von einer Wiederholungsrate (mod8) einer Wandlerstruktur des A/D-Wandlers (AD) zur Korrektur auszuwählen.

17. Schaltungsanordnung nach einem der Ansprüche 14 bis 16, bei der die vom A/D-Wandler (AD) ausgegebenen digitalen Werte (d) einem Eingang eines Subtraktionsglieds (S4) und einem Eingang eines Verzögerungsglieds (V) angelegt werden, wobei ein Ausgang des Verzögerungsglieds (V) an einem weiteren Eingang des Subtraktionsglieds (S4) anliegt und ein Ausgang des Subtraktionsglieds (S4) an der Korrektureinrichtung (DC) zum Erzeugen von dynamischen Korrekturwerten (kd) unter Berücksichtigung der dynamischen Koeffizienten (dc) anliegt.

18. Schaltungsanordnung nach einem der Ansprüche 12 bis 17 mit einem Kerbfilter (NF) zum Filtern der vom A/D-Wandler (AD) ausgegebenen digitalen Werte (d) unter Berücksichtigung von Testsignalfrequenzen (f1, f2), welche zur Koeffizientenbestimmung verwendet wurden.

19. Schaltungsanordnung nach einem der Ansprüche 12 bis 18 mit einem Kerbfilter (NF) zum Filtern der vom A/D-Wandler (AD) ausgegebenen digitalen Werte (d) zum Bereitstellen von Aktualisierungswerten für die Koeffizienten (sc, dc).

20. Schaltungsanordnung nach einem der Ansprüche 12 bis 19 mit Komponenten zum Durchführen eines Verfahrens nach einem der Ansprüche 1 bis 11.
